Europäisches Patentamt

European Patent Office

Office européen des brevets

(19)

(11) **EP 1 028 533 A1**

(12) **EUROPEAN PATENT APPLICATION**

(43) Date of publication:
**16.08.2000 Bulletin 2000/33**

(51) Int. Cl.⁷: **H03M 13/45**, H03M 13/25,
H03M 13/15

(21) Application number: **00200352.3**

(22) Date of filing: **03.02.2000**

(84) Designated Contracting States:
**AT BE CH CY DE DK ES FI FR GB GR IE IT LI LU
MC NL PT SE**
Designated Extension States:
**AL LT LV MK RO SI**

(30) Priority: **09.02.1999 GB 9902807**

(71) Applicant:
**Tandberg Television ASA
1326 Lysaker (NO)**

(72) Inventors:
• **Markarian, Garegin
Southampton, Hampshire SO50 9NW (GB)**

• **Pickavance, Keith
Southampton, Hampshire SO51 7RW (GB)**
• **Waddington, Simon
Southampton, Hampshire SO17 2HQ (GB)**
• **White, Paul
Eastleigh, Hampshire SO53 5QP (GB)**

(74) Representative:
**Sturt, Clifford Mark
Miller Sturt Kenyon
9 John Street
London WC1N 2ES (GB)**

(54) **Decoding an input digital signal**

(57)     The invention relates to decoding an input digital signal comprising signals representing encoded and uncoded bits. The invention is particularly applicable to digital television signal transmission employing pragmatic trellis coded modulation schemes..

The invention provides for decoding the input digital signal by forming hard decision estimates and soft decision estimates of the uncoded bits. The symbols are decoded by reference to the encoded bits and the hard decision estimates. The symbols are also decoded by reference to the encoded bits and the soft decision estimates. Those symbols that are decoded by reference to the hard decision estimates are selected in preference to the same symbols decoded by reference to the soft decision estimates.

## Fig.1.

EP 1 028 533 A1

**Description**

The present invention relates to decoding an input digital signal comprising symbols representing encoded and uncoded bits.

In the transmission and decoding of encoded digital signals there is an ever-increasing demand for higher information rates and better error performance. This demand has dictated the use of higher order modulation techniques combined with error control coding. In particular, in the field of digital television signal transmission, the use of pragmatic trellis coded modulation schemes is recommended as a standard in Europe with variable code rates R = 2/3 and so on up to 8/9 and M-ary modulation schemes where M = 8 and M = 16. A similar approach has been accepted in the USA where a digital television standard is recommended using pragmatic trellis coded modulation with a code rate R = 1/2 and a vestigial sideband (VSB) modulation scheme which is an 8VSB (M = 8) or a 16VSB (M = 16) modulation scheme.

Conventional pragmatic trellis coded modulation and decoding provides different levels of error protection for different bits of binary data. In the case of 8-PSK modulation with a code rate of 2/3, for example, for every encoded (protected) bit there is one uncoded or unprotected bit. In the case of 8-PSK modulation where the code rate is 5/6 and one coded bit per symbol, for every one encoded (protected) bit there are four uncoded or unprotected bits. The uncoded bits are less reliable in comparison with the encoded bits and it would therefore be desirable to devise ways of providing reliability estimates of the uncoded bits.

In known soft output Viterbi decoder techniques, reliability values are provided, but only for encoded bits. The application of such decoder techniques to pragmatic trellis coded modulation is therefore not readily apparent. Conventional erasure decoders are prone to the generation of "wrong erasures" in which correctly received symbols with low indicated reliability are incorrectly signalled as erasures. This reduces the error control capability of the code.

It is an aim of the present invention to provide an improvement in the error performance of a decoder for decoding an input digital signal comprising symbols representing encoded and uncoded bits.

According to the present invention, there is now provided a method of decoding an input digital signal comprising symbols representing encoded and uncoded bits, the method comprising the steps of: forming hard decision estimates of the uncoded bits and soft decision estimates of the uncoded bits; decoding the symbols by reference to the encoded bits and the hard decision estimates; decoding the symbols by reference to the encoded bits and the soft decision estimates; and, selecting symbols successfully decoded by reference to the hard decision estimates in preference to the same symbols decoded by reference to the soft decision estimates.

Further according to the present invention, there is provided decoder apparatus to decode an input digital signal comprising symbols representing encoded and uncoded bits, the decoder apparatus comprising: means to form hard decision estimates of the uncoded bits; means to form soft decision estimates of the uncoded bits; a first decoder to decode the symbols by reference to the encoded bits and hard decision estimates; a second decoder to decode the symbols by reference to the encoded bits and soft decision estimates; and, a multiplexer controlled to select symbols successfully decoded by the first decoder in preference to the same symbols decoded by the second decoder.

The invention will now be described, by way of example, with reference to the accompanying drawings in which:

Figure 1 shows a block diagram of a known pragmatic trellis coded 8-PSK modulator using a rate 1/2 convolutional encoder;

Figure 1a shows a block diagram of a concatenated modulation system employing the modulator of Figure 1;

Figure 2 shows a block diagram of a known pragmatic trellis coded 8-PSK modulator using a rate 1/2 convolutional encoder;

Figure 2a shows a block diagram of a concatenated modulation system employing the modulator of Figure 2;

Figures 3 and 4 show block diagrams of known decoder apparatus for use in decoding the modulated signals generated by the modulators of Figures 1 and 2 respectively;

Figures 3a and 4a show block diagrams of demodulating systems for demodulating the signals generated by the modulators in Figures 1a and 2a respectively;

Figures 5 and 6 show decoder apparatus, according to the present invention, for decoding the modulated signals generated by means of the modulators in Figures 1 and 2 respectively, and giving additional information on erasure locations;

Figures 5a and 6a show decoder apparatus for decoding the modulated signals generated by means of the modulators in Figures 1a and 2a;

Figure 7 shows a block diagram of an erasure decoder, according to the invention, included in the decoder apparatus of Figures 5a and 6a;

Figure 8 shows a soft decision metric generator included in the decoder apparatus of Figures 5a and 6a; and,

Figure 9 shows a known pragmatic trellis coded modulator in conjunction with an interference filter pre-coder and 8-level vestigial side band modulation.

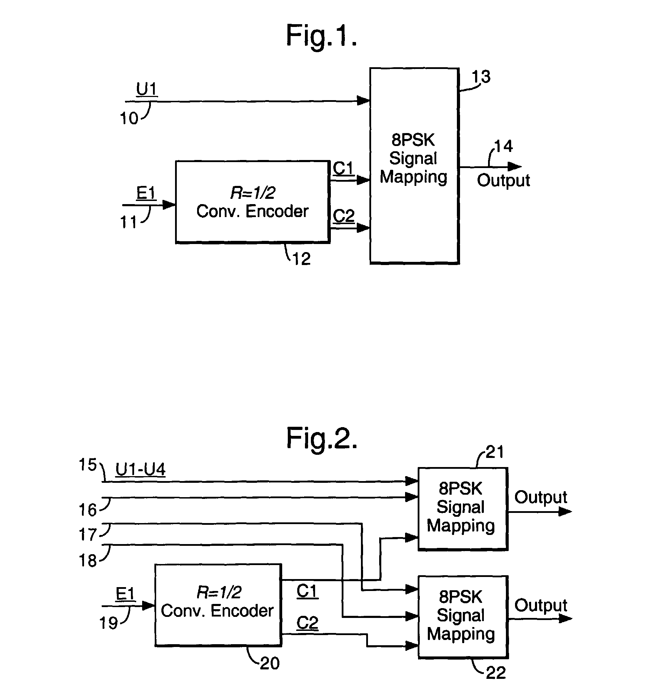

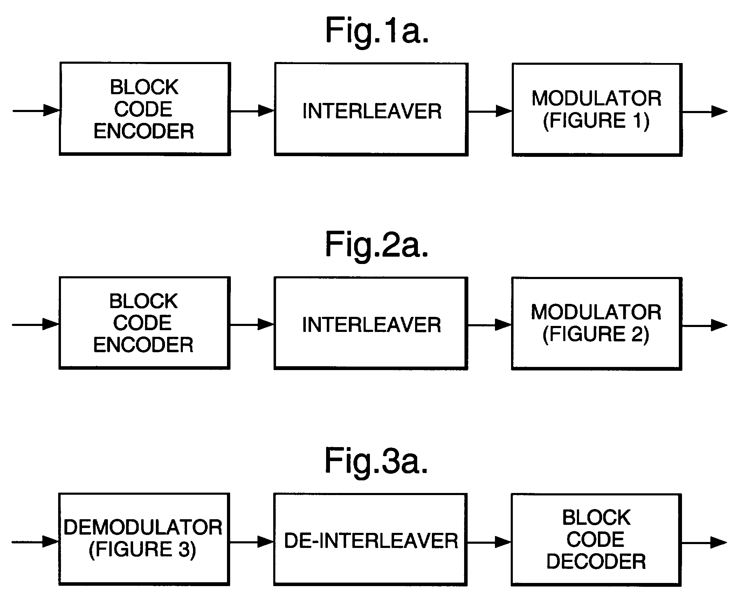

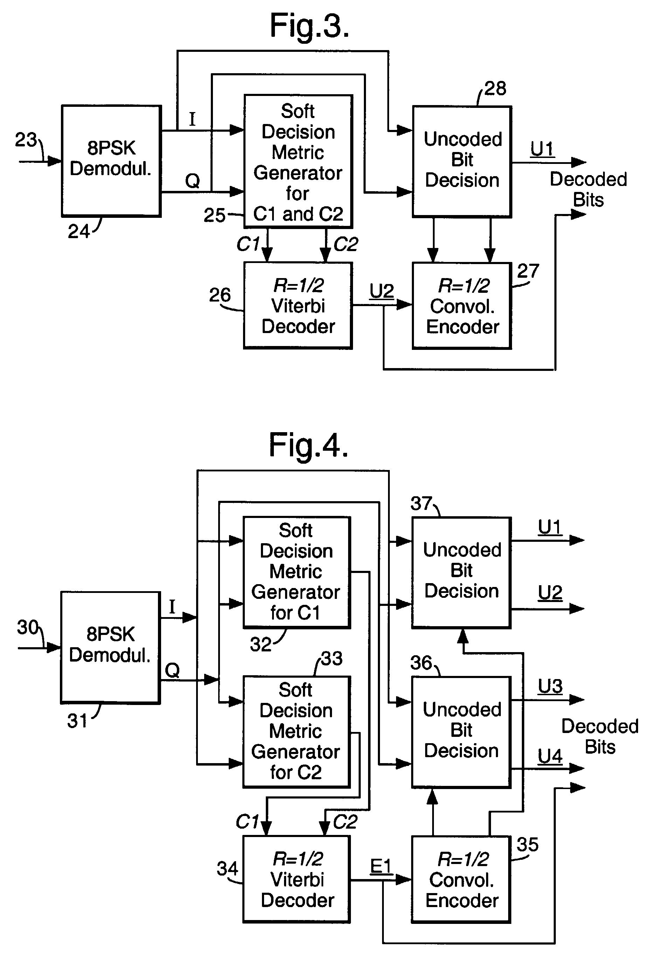

In Figure 1, an input bit U1 of an input symbol is applied to an input terminal 10. Another bit E1 of the symbol is applied to an input terminal 11. The input terminal 11 is connected to supply the bit E1 to a convolutional encoder 12 having a code rate R = 1/2. The output from the convolutional encoder consists of two bits C1 and C2 for each input bit E1. C1 and C2 are bits which represent the convolutional encoding of the input bit E1. The bits U1, C1 and C2 are supplied to an 8-PSK signal mapping module 13 which maps the three bits to an 8-PSK modulation of the output signal on the output terminal 14. The output modulated signal includes symbols which represent one uncoded bit U1 and two convolutional encoded bits C1 and C2. The output modulated signal is transmitted to a decoder which will be described with reference to Figure 3.

Figure 1a shows the modulator of Figure 1 included in a concatenated modulation system which also includes a block code encoder and an interleaver.

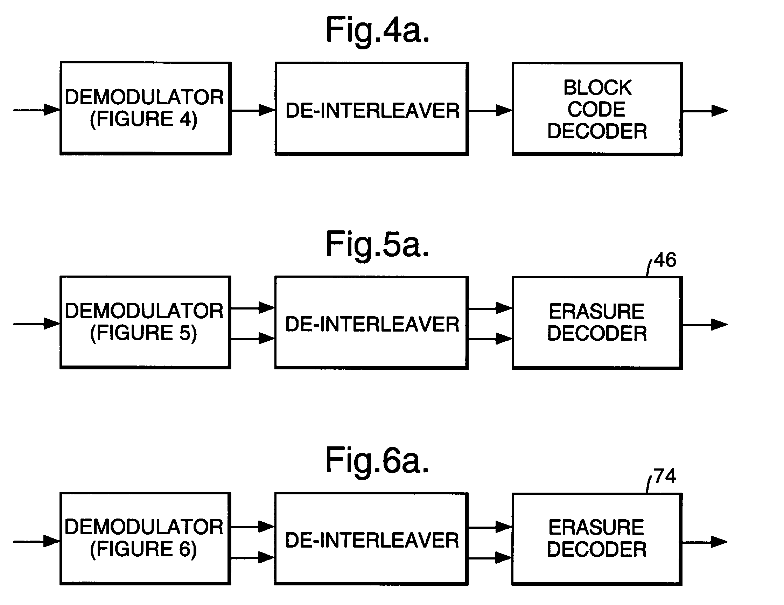

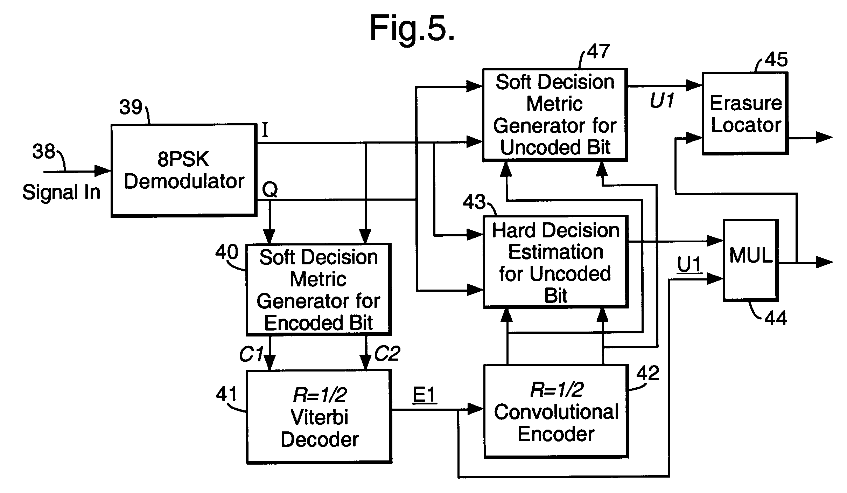

In Figure 2, four input bits U1 to U4 are applied in parallel to input terminals 15 to 18 respectively and an input bit E1 is applied to an input terminal 19. The input terminal 19 is connected to supply the bit E1 to a convolutional encoder 20 having a code rate R = 1/2. The output from the convolutional encoder 20 consists of two bits C1 and C2 for each input bit E1. C1 and C2 represent the convolutional encoding of the input bit E1. The input bits U1 and U2 and the bit C1 are applied as input to an 8-PSK mapping circuit 21 while the input bits U3, U4 and the bit C2 are applied to an 8-PSK mapping circuit 22. Each of the mapping circuits 21 and 22 maps its respective three bits to a symbol of an 8-PSK modulated output. The symbols are interleaved before onward transmission to a decoder which will be described with reference to Figure 4. It will be apparent that the modulator of Figure 2 has a code rate R = 5/6. The two output symbols represent the four uncoded bits U1 to U4 and the two convolutionally encoded bits C1 and C.

In Figure 2a the modulator of Figure 2 is shown included in a concatenated modulation system which also includes a block code and an interleaver.

In Figure 3, a decoder has an input terminal 23 to receive the 8-PSK modulated signal output from the encoder of Figure 1. A demodulator 24 demodulates the 8-PSK modulated signal to produce I and Q quadrature components. The I and Q components are supplied to a module 25 which generates a soft-decision metric representation of the soft-decision metric representation of bits C1 and C2 of each symbol. The bits C1 and C2 are applied to a Viterbi decoder 26 which decodes the bits C1 and C2 to reproduce the decoder estimate $\underline{U2}$ of the encoded bit E1 of each symbol. The bit E1 is supplied to a convolution encoder 27 of code rate R = 1/2 to generate two convolutionally encoded bits for each decoded bit E1. The convolutionally encoded bits from the encoder 27 are applied to a module 28.

The module 28 receives the quadrature components I and Q from the demodulator 24 and produces a bit decision for each symbol. The bit decision specifies the decoder estimate of the uncoded bit $\underline{U1}$ and is determined by the I and Q components from the demodulator 24 and the convolutionally encoded bits from the encoder 27. The output $\underline{U2}$ from the decoder 26 and the output $\underline{U1}$ from the module 28 represent the output from the decoder.

In Figure 3a the demodulator of Figure 3 is shown incorporated into a system which also includes a de-interleaver and a block code decoder.

In Figure 4, a decoder has an input terminal 30 to receive the 8-PSK modulated signal output from the encoder of Figure 2. A demodulator 31 demodulates the 8-PSK modulated signal to produce I and Q quadrature components. The I and Q components are supplied to modules 32 and 33 which generates a soft decision metric representation of bits C1 and C2 respectively. The soft decision metric representation of bits C1 and C2 are applied to a Viterbi decoder 34 of rate R = 1/2 which produces the decoder estimate of the encoded bit E1. The decoder estimate $\underline{E1}$ of the bit E1 is supplied to a convolution encoder 35 of data rate R = 1/2 to generate two convolutionally encoded bits for each estimate $\underline{E1}$. The two convolutionally encoded bits from the encoder 35 are applied to two modules 36 and 37 respectively.

The module 37 receives the quadrature components I and Q from the demodulator 31 and produces bit decisions specifying the estimates $\underline{U1}$ and $\underline{U2}$ of the uncoded bits U1 and U2. The bit decisions depend on the I and Q components from the demodulator 31 and the convolutionally encoded bit from the encoder 35. The module 37 receives the quadrature components I and Q from the demodulator 31 and produces bit decisions specifying the estimates $\underline{U3}$ and $\underline{U4}$ of the uncoded bits U3 and U4. The bit decisions produced by the module 37 depend on the I and Q components from the demodulator 31 and the convolutionally encoded bit from the encoder 35. The output $\underline{E1}$ from the decoder 34 and the outputs $\underline{U1}$ to $\underline{U4}$ from the modules 36 and 37 represent the decoded output from the decoder.

In Figure 4a the demodulator of Figure 4 is shown incorporated into a system which also includes a de-interleaver and a block code decoder.

For known apparatus such as those of Figures 3 and 4, it is also known for each bit regenerated by application of a soft decision metric generator to have an associated measurer of the probability of the bit having been regenerated correctly. This measure is known as the reliability value.

Figure 5 shows a decoder for decoding the modulated signal generated by the modulator of Figure 1. The decoder of Figure 5 is an improvement, according to the present invention, over the decoder of Figure 3, in that it also outputs reliability information which can be used by an outer erasure decoder. The decoder of Figure 5 receives the 8-PSK modulated signal from the modulator of Figure 1 through an input terminal 38. A demodulator 39 demodulates the 8-PSK modulated signal to produce I and Q quadrature components. The I and Q components are supplied to a module 40 which generates a soft decision metric representation of the bits C1 and C2 of each symbol. The soft decision metric representation of bits C1 and C2 are applied to a Viterbi decoder 41 which decodes the bits C1 and C2 to produce an estimate of $\underline{E1}$ of the encoded bit E1 of each symbol. The bit $\underline{E1}$ is supplied to a convolutional encoder 42 of code rate R = 1/2 to generate two convolutionally encoded bits for each decoded bit E1. The convolutionally encoded bits from the encoder 42 are applied to a module 43.

The module 43 receives the quadrature components I and Q from the demodulator 39 and produces a hard decision estimation $\underline{U1}$ of the uncoded bit in each symbol. The hard bit decision specifies an estimate of the uncoded bit U1 and is determined by the I and Q components from the demodulator 39 and the convolutionally encoded bits from the encoder 42. The output $\underline{E1}$ from the Viterbi decoder 41 is the same as the output which is produced by the Viterbi decoder 26 of Figure 3 and the output $\underline{U1}$ from the module 43 is the same as the output which is produced by the module 28 of Figure 3. In the Figure 5 decoder, however these outputs are supplied to a multiplexer 44 which multiplexes the bits and supplies them to an erasure locator 45.

A module 47 receives the I and Q quadrature components from the demodulator 39 in parallel with the modules 40 and 43. The module 47 applies a soft decision metric to generate a soft decision estimation for the uncoded bit by reference to the I and Q components and by reference to the output from the convolutional encoder 42. The soft decision estimation from the module 47 is supplied as a second input to the erasure locator 45. The erasure locator 45 operates in conventional manner to signal erasure locations in the symbols received at the input terminal 38 based on the inputs from the multiplexer 44 and from the module 47. For every soft value of U1 that is received by the erasure locator 45, there are two hard decision values U1 and E1. The erasure locator accumulates 8 hard decision values, 4 soft decision values and generates one symbol from the $GF(2^8)$. If the lowest reliability value is treated as an erasure, the whole symbol will be treated as an erasure and the erasure locator generates a value of "1". If the received symbol is acknowledged as reliable, the erasure locator generates a "0".

Figure 5a shows a concatenated demodulation scheme for the modulated signal produced by the modulator shown in Figure 1a. According to the present invention, this gives a performance improvement over the demodulator of Figure 3a by passing erasure locations to the outer block code decoder 46.

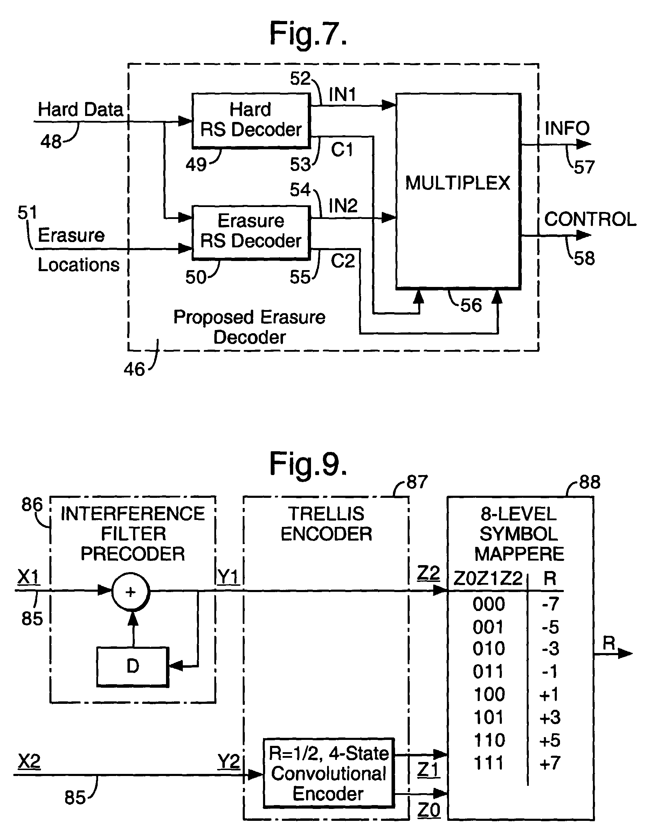

The erasure decoder 46 is shown in further detail in Figure 7. The hard data from the multiplexer 44 is applied at an input terminal 48 to a hard Reed Solomon decoder 49 and an erasure Reed Solomon decoder 50. The erasure locations from the erasure locator 45 are applied to an input terminal 51 to the erasure decoder 50. Each of the decoders 49 and 50 provides two output signals. The decoder 49 provides an output signal IN1 on a terminal 52 which represents the decoded information symbol and a control signal C1 on a terminal 53. The control signal C1 has a value of 0 if the decoder 49 is capable of correctly decoding the received code and has a value of 1 if the number of errors in the received code indicates uncorrectable errors. The decoder 50 provides an output signal IN2 on a terminal 54 which represents the decoded information symbol and a control signal C2 on a terminal 55. The control signal C2 has a value of 0 if the decoder 50 is capable of correctly decoding the received code and has a value of 1 if the number of errors in the received code exceeds the error control capability of the code.

The signals IN1, IN2, C1 and C2 on the terminals 52 to 55 are supplied to a multiplexer 56. The multiplexer 56 produces an INFO signal on an output terminal 57 and a control signal on an output terminal 58 according to the following look-up Table I;

TABLE I

| Control Signal C1 | Control Signal C2 | INFO Signal Out | CONTROL Signal Out |
|:---:|:---:|:---:|:---:|
| 0 | 0 | IN1 | 0 |
| 0 | 1 | IN1 | 0 |

TABLE I (continued)

| Control Signal C1 | Control Signal C2 | INFO Signal Out | CONTROL Signal Out |
|---|---|---|---|
| 1 | 0 | IN2 | 0 |
| 1 | 1 | IN1 | 1 |

The logic of the overall decoding can be described in relation to the look-up Table I as follows:

If both the hard decision decoder 49 and the erasure decoder 50 are capable of correcting the received codeword, the output from the hard decision decoder 49 is selected in preference to the output from the erasure decoder 50 and passed to the information terminal 57. The control terminal 58 receives a control signal 0;
If only the hard decision decoder 49 is capable of correcting the received codeword, the output from the hard decision decoder is selected and passed to the information terminal 57. The control terminal 58 receives a control signal 0;
If only the hard decision decoder 49 reports a failure to decode, the output from the erasure decoder is selected and passed to the information terminal 57. The control terminal 58 receives a control signal 0;
If both decoders 49 and 50 report failure, the overall decoder reports failure by putting a control signal 1 on the control terminal 58 and the output from the hard decision decoder 49 on the information terminal 57.

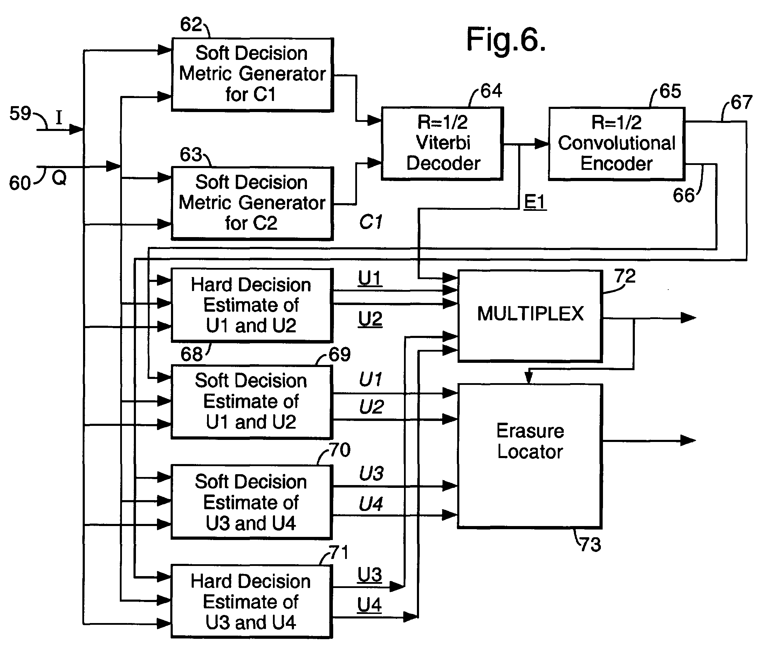

Figure 6 shows a decoder for decoding the modulated signal generated by the modulator of Figure 2. The decoder of Figure 6 is an improvement, according to the present invention, over the decoder of Figure 4, in that it outputs additional reliability information that can be used by an outer erasure decoder. The decoder of Figure 6 receives the 8-PSK modulated signal from the modulator of Figure 2. The decoder includes a demodulator (not shown) which demodulates the 8-PSK modulated signal to produce I and Q quadrature components on terminals 59 and 60. The I and Q components are supplied to modules 62 and 63 which generates a soft decision metric representation of the bits C1 and C2 respectively. The soft decision metric representation of bits C1 and C2 are applied to a Viterbi decoder 64 of rate R = 1/2 which produces an estimate $\underline{E1}$ of the encoded bit E1 of each symbol. The decoder estimate of bit E1 is supplied to a convolution encoder 65 of code rate R = 1/2 to generate two convolutionally encoded bits for each estimated bit $\underline{E1}$. The two convolutionally encoded bits from the encoder 65 are applied to two terminals 66 and 67 respectively.

The terminal 66 is connected to modules 68 and 69 and the terminal 67 is connected to modules 70 and 71. The modules 68, 69, 70 and 71 are connected to receive the I and Q quadrature components from the input terminals 59 and 60. The modules 68 and 69 produce hard and soft decision estimates of the bits U1 and U2 and the modules 70 and 71 produce hard and soft decision estimates of the bits U3 and U4. The hard decision estimates U1 to U4 and the estimate of E1 are applied to a multiplexer 72. The soft decision estimates U1 to U4 are applied to an erasure locator 73.

Figure 6a shows a concatenated demodulation scheme for the modulated signal produced by the modulator in Figure 2a. According the present invention, this gives a performance improvement over the modulator of Figure 4a, by passing erasure locations to the outer block code. The erasure decoder 74 is as shown in Figure 7, the construction and operation of which has already been described.

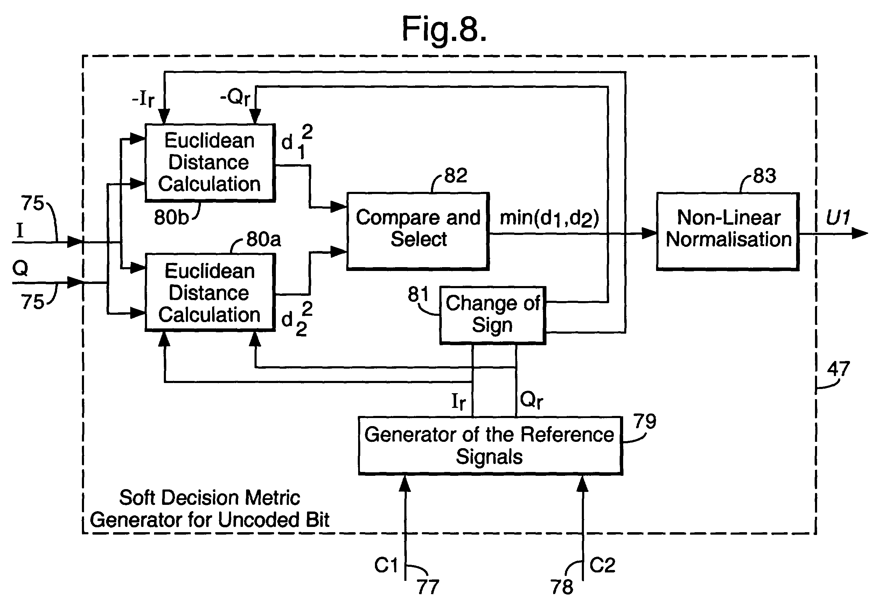

Figure 8 shows the construction of the module 47 in the decoder of Figure 5. The I and Q quadrature components from the demodulator 39 are supplied to the module 47 through terminals 75 and 76. The convolutionally encoded bits from the encoder 42 are supplied through terminals 77 and 78. The terminals 77 and 78 are connected to a reference signal generator 79 which generates reference signals $I_R$ and $Q_R$ according to the following Table II:

TABLE II

| C1 | C2 | $I_R$; $Q_R$ |
|---|---|---|
| 0 | 0 | ( $\cos\pi/8$ ; $\sin\pi/8$ ) |
| 0 | 1 | ( $\cos3\pi/8$ ; $\sin3\pi/8$ ) |
| 1 | 0 | ( $\cos\pi/8$ ; $-\sin\pi/8$ ) |
| 1 | 1 | ( $\cos3\pi/8$ ; $-\sin3\pi/8$ ) |

The signals $I_R$ and $Q_R$ assume a particular constellation orientation and unit length symbol amplitude. The signals $I_R$ and $Q_R$ are applied to a Euclidean distance calculating module 80a and to a change of sign module 81. The module 81 changes the signs of the signals $I_R$ and $Q_R$ to produce signals $-I_R$ and $-Q_R$ which are applied to a Euclidean distance calculating module 80b. The received signal components I and Q on the input terminals 75 and 76 are applied to the modules 80a and 80b. Each module calculates the Euclidean distance between the received signal components I and Q and the reference signals generated by the generator 79 to produce output signals $d_1{}^2$ and $d_2{}^2$. The distance calculations for $d_1{}^2$ and $d_2{}^2$ are made according to the formulae:

$$d_1{}^2 = (I - I_R)^2 + (Q - Q_R)^2$$

and

$$d_2{}^2 = (I + I_R)^2 + (Q + Q_R)^2$$

The signals $d_1{}^2$ and $d_2{}^2$ are applied to a compare and select block 82 which compares those signals and selects the minimum value between the calculated Euclidean distances. The selected value is normalised by means of a module 83 with reference to an erasure threshold $A_0$. If $|d_1{}^2 - d_2{}^2| < A_0$ an erasure is declared.

The value of $A_0$ is defined in relation to the channel conditions. The reliability value of the uncoded bit is a complicated function which depends on the probability density function of the noise, signal-to-noise ratio in the channel and the set partitioning of the pragmatic trellis coded modulation. The normalisation provides good matching for the Additive White Gaussian Channel Noise.

In Figure 9, input symbols comprising bits X1 and X2 are entered on lines 84 and 85 in a first stage. An interference filter pre-coder 86 is used to pre-code the bits on line 84. In a second stage, the bits of the symbols are labelled Y1 and Y2 and enter a trellis encoder 87 in which the Y2 bits are encoded by means of a 4-state convolutional encoder having a code rate R = 1/2. The output bits from the trellis encoder, labelled Z0, Z1, and Z2 are applied to an 8-level symbol mapper 88 which maps the values of the bits Z0, Z1 and Z2 to values R for an 8-VSB modulation. It will be apparent that the arrangement shown in Figure 9 is similar to the block diagram of Figure 1 for 8PSK and R = 2/3 with minor differences for the pre-coding of the uncoded bit and trellis structure of the R = 1/2 convolutional encoder. Thus, the proposed partial soft output pragmatic decoder for 8 PSK and R = 2/3 shown in Figure 5 can be used (after appropriate alterations in the demodulator) for the decoding of signals produced by the construction of Figure 9.

**Claims**

1.  A method of decoding an input digital signal comprising symbols representing encoded and uncoded bits, the method comprising the steps of: forming hard decision estimates of the uncoded bits and soft decision estimates of the uncoded bits;

    decoding the symbols by reference to the encoded bits and the hard decision estimates;
    decoding the symbols by reference to the encoded bits and the soft decision estimates: and,
    selecting symbols successfully decoded by reference to the hard decision estimates in preference to the same symbols decoded by reference to the soft decision estimates.

2.  A method as claimed in Claim 1, wherein hard decision estimates of the encoded bits are used to generate the soft decision estimates of the uncoded bits.

3.  A method as claimed in Claim 1 or 2, wherein the step of decoding the symbols by reference to the hard decision estimates is performed by a hard Reed Solomon decoder and the step of decoding the symbols by reference to the soft decision estimates is performed by means of an erasure Reed Solomon decoder.

4.  A method as claimed in any one of the preceding Claims which is applied to decoding an input digital signal which is a digital television signal.

5.  A method as claimed in any one of the preceding Claims in which the symbols consist of three bits of which one is uncoded and two are encoded.

6.  A method as claimed in any one of Claims 1 to 4 in which the symbols consist of three bits of which two are uncoded and one is encoded.

7.  Decoder apparatus to decode an input digital signal comprising symbols representing encoded and uncoded bits, the decoder apparatus comprising:

means to form hard decision estimates of the uncoded bits;
means to form soft decision estimates of the uncoded bits;
a first decoder to decode the symbols by reference to the encoded bits and hard decision estimates;
a second decoder to decode the symbols by reference to the encoded bits and soft decision estimates; and,
a multiplexer controlled to select symbols successfully decoded by the first decoder in preference to the same symbols decoded by the second decoder.

8.  Decoder apparatus as claimed in Claim 7, wherein the means to form soft decision estimates of the uncoded bits is adapted to derive the said soft decision estimates from hard decision estimates of the encoded bits.

9.  Decoder apparatus as claimed in Claim 7 or 8 wherein, the first decoder is a hard Reed Solomon decoder and the second decoder is an erasure Reed Solomon decoder.

10.  Decoder apparatus as claimed in any one of Claims 7 to 9, which is adapted to decode an input digital signal which is a digital television signal.

11.  Decoder apparatus as claimed in any one of Claims 7 to 10, which is adapted to decode an input digital signal in which the symbols consist of three bits of which one is uncoded and two are encoded.

12.  Decoder apparatus as claimed in any one of Claims 7 to 10, which is adapted to decode an input digital signal in which the symbols consist of three bits of which two are uncoded and one is encoded.

# Fig.1.

# Fig.2.

EP 1 028 533 A1

# Fig.1a.

| BLOCK CODE ENCODER | → | INTERLEAVER | → | MODULATOR (FIGURE 1) |
|---|---|---|---|---|

# Fig.2a.

| BLOCK CODE ENCODER | → | INTERLEAVER | → | MODULATOR (FIGURE 2) |
|---|---|---|---|---|

# Fig.3a.

| DEMODULATOR (FIGURE 3) | → | DE-INTERLEAVER | → | BLOCK CODE DECODER |
|---|---|---|---|---|

# Fig.3.

# Fig.4.

## Fig.4a.

```
          ┌──────────────┐       ┌──────────────┐       ┌──────────────┐
   ──────▶│ DEMODULATOR  │──────▶│ DE-INTERLEAVER│──────▶│    BLOCK     │──────▶
          │ (FIGURE 4)   │       │              │       │    CODE      │
          └──────────────┘       └──────────────┘       │   DECODER    │
                                                         └──────────────┘
```

## Fig.5a.

```
          ┌──────────────┐       ┌──────────────┐       ┌──────────────┐ 46
   ──────▶│ DEMODULATOR  │═════▶ │ DE-INTERLEAVER│═════▶ │   ERASURE    │──────▶
          │ (FIGURE 5)   │       │              │       │   DECODER    │
          └──────────────┘       └──────────────┘       └──────────────┘
```

## Fig.6a.

```
          ┌──────────────┐       ┌──────────────┐       ┌──────────────┐ 74
   ──────▶│ DEMODULATOR  │═════▶ │ DE-INTERLEAVER│═════▶ │   ERASURE    │──────▶
          │ (FIGURE 6)   │       │              │       │   DECODER    │
          └──────────────┘       └──────────────┘       └──────────────┘
```

EP 1 028 533 A1

# Fig.5.

Fig.6.

## Fig.7.

Proposed Erasure
Decoder

## Fig.9.

| Z0Z1Z2 | R |
|--------|-----|
| 000 | -7 |
| 001 | -5 |
| 010 | -3 |
| 011 | -1 |
| 100 | +1 |
| 101 | +3 |
| 110 | +5 |
| 111 | +7 |

# Fig.8.

Soft Decision Metric
Generator for Uncoded Bit

European Patent Office

**EUROPEAN SEARCH REPORT**

Application Number

EP 00 20 0352

## DOCUMENTS CONSIDERED TO BE RELEVANT

| Category | Citation of document with indication, where appropriate, of relevant passages | Relevant to claim | CLASSIFICATION OF THE APPLICATION (Int.Cl.7) |
|---|---|---|---|
| A | WANG HUA ET AL: "A Concatenating Coding Scheme Employing Pragmatic Multidimensional Trellis Code and RS Code for Satellite Communications" INTERNATIONAL CONFERENCE ON COMMUNICATION TECHNOLOGY ICCT'98, 22 - 24 October 1998, pages S38.10.1-S38.10.4, XP002136537 Beijing, China * the whole document * | 1-12 | H03M13/45 H03M13/25 H03M13/15 |
| A | EP 0 652 643 A (TOKYO SHIBAURA ELECTRIC CO) 10 May 1995 (1995-05-10) * column 1, line 5 - line 9 * * column 4, line 1 - column 5, line 6 * * column 8, line 22 - column 9, line 44 * | 1-12 | |
| A | FR 2 754 960 A (MITSUBISHI ELECTRIC CORP) 24 April 1998 (1998-04-24) | | |
| A | EP 0 494 709 A (PHILIPS ELECTRONICS UK LTD ;KONINKL PHILIPS ELECTRONICS NV (NL)) 15 July 1992 (1992-07-15) | | TECHNICAL FIELDS SEARCHED (Int.Cl.7) |
| | | | H03M H04L |

The present search report has been drawn up for all claims

| Place of search | Date of completion of the search | Examiner |
|---|---|---|
| THE HAGUE | 27 April 2000 | Ogor, M |

EP 1 028 533 A1

## ANNEX TO THE EUROPEAN SEARCH REPORT
## ON EUROPEAN PATENT APPLICATION NO.

EP 00 20 0352

This annex lists the patent family members relating to the patent documents cited in the above-mentioned European search report.
The members are as contained in the European Patent Office EDP file on
The European Patent Office is in no way liable for these particulars which are merely given for the purpose of information.

27-04-2000

| Patent document cited in search report | | Publication date | Patent family member(s) | | Publication date |
|---|---|---|---|---|---|
| EP 0652643 | A | 10-05-1995 | JP | 7131493 A | 19-05-1995 |
| | | | JP | 7131494 A | 19-05-1995 |
| | | | CA | 2134996 A,C | 05-05-1995 |
| | | | KR | 181983 B | 15-04-1999 |
| | | | US | 5651032 A | 22-07-1997 |
| FR 2754960 | A | 24-04-1998 | JP | 10178355 A | 30-06-1998 |
| | | | CA | 2217044 A | 18-04-1998 |
| | | | CN | 1181663 A | 13-05-1998 |
| EP 0494709 | A | 15-07-1992 | AU | 658597 B | 27-04-1995 |
| | | | AU | 1007092 A | 16-07-1992 |
| | | | CA | 2058775 A | 10-07-1992 |
| | | | CS | 9200035 A | 15-07-1992 |
| | | | DE | 69225619 D | 02-07-1998 |
| | | | DE | 69225619 T | 24-12-1998 |
| | | | JP | 5048546 A | 26-02-1993 |
| | | | SG | 44761 A | 19-12-1997 |
| | | | US | 5233349 A | 03-08-1993 |

EPO FORM P0459

For more details about this annex : see Official Journal of the European Patent Office, No. 12/82

17